**Europäisches Patentamt**

**European Patent Office**

**Office européen des brevets**

(19)

(11) Publication number: **0 121 992**
**A2**

(12)

# EUROPEAN PATENT APPLICATION

(21) Application number: **84300973.9**

(22) Date of filing: **15.02.84**

(51) Int. Cl.³: **H 03 H 21/00**

(30) Priority: **11.04.83 US 484055**

(43) Date of publication of application: **17.10.84**
**Bulletin 84/42**

(84) Designated Contracting States: **DE FR GB**

(71) Applicant: **ROCKWELL INTERNATIONAL CORPORATION, 1200 N. Alma Road, Richardson Texas 75081 (US)**

(72) Inventor: **Bruckner, Juergen Manfred Harald, 260 Brentwood Circle, Cedar Rapids Iowa 52402 (US)**

(74) Representative: **Jackson, David Spence et al, REDDIE & GROSE 16, Theobalds Road, London, WC1X 8PL (GB)**

(54) **Optimal covariance filtering.**

(57) A multirate optimal filtering technique allows for higher sampling rates with the same processing time throughput or greater throughput for a fixed sampling rate. In many instances, the measurement sampling rate dictated by the system dynamics is much higher than that required for time varying gain considerations. Thus, the optimal gain remains fairly constant for several consecutive measurements. Under such circumstances, the covariance and optimal gain computations can be processed at a slower rate than the filter measurement computations when the optimal gains are appropriately adjusted for use by the higher processing rate measurement equations. This increases the processing throughput for any given sampling rate or allows increased measurement sampling for a fixed throughput time.

## OPTIMAL COVARIANCE FILTERING

The present invention relates to measuring and filtering techniques, and more particularly to real time covariance filtering.

In the prior art, there are known a variety of data processing techniques for estimating random variables of a particular type. These techniques have evolved into modern multi-sensor systems using filters exemplified by the well known Kalman type. Such data processing is generally known as optimal estimation in which a computational algorithm operates on certain data measurements to produce an estimation of the state of a system with minimum error. These techniques utilize certain facts relating to system operation, initial conditions, system dynamics and assumptions on system noises and are designed to minimize estimation error by using all known measurement data and knowledge about the system. Such estimation, when applied to detect a real-time measurement point, is referred to as optimal covariance filtering.

One of the most common filtering techniques is the above-referenced Kalman technique. The Kalman filter has been used with a variety of data processing systems including process control and navigation. Such systems may be single sensor or multiple sensor systems which are constructed to produce a resultant output that provides the most acceptable estimate of the system state. The estimates are usually implemented by computer processing of sensor data in which measurement samples and covariance and optimal gain computations are processed in the filtering equations. Such measurements, when compared with other system measurements, can be utilized to produce an accuracy which is greater than the external measurements alone or the measurement system alone.

By way of example, optimal estimation techniques are often used in navigation systems. In such instances, external measurements have been used to update navigation variables to null out the measurement errors. However, the external measurements and the navigation system may both contain random errors. When

0121992

optimal estimation techniques are employed, such as Kalman filtering and other similar filtering, the estimate of navigation position is based upon the use of all available external measurements to improve the system accuracy. In many cases, the external measurements are made at high sampling rates dictated by the dynamics of the system and require the computation of covariance and gains at the high rates to produce the filter estimation.

In the prior art, the measurement sampling rate dictated by the system dynamics is carried on at the same rate as the computation of covariance and gain to produce the optimal filtering. The covariance and gain computations require much greater throughput than the measurement update equations. Accordingly, the capacity of the filtering system is limited by the speed of the data processing hardware to process the covariance and gain computations within the required time constraints. In navigation systems in particular, it has been found that the throughout rate required for optimal filtering for slowly moving vehicles is sufficient to be handled by conventional hardware. As the conditions under which the measurements are made change, however, and require faster throughput processing, conventional hardware is incapable of providing the requisite processing to produce usable results. In aircraft applications, for example, using multiple measurements from a multisensor satellite-based navigation system, the processing required to produce real-time optimal filtering estimation of aircraft position suitable for use by an automatic flight control system cannot be achieved with state-of-the-art microprocessor hardware. Such filtering techniques are therefore incapable of providing the requisite estimation of aircraft position and velocity on a real-time basis.

Accordingly, the present invention has been developed to overcome the shortcomings of the above known and similar techniques, and to provide a multirate optimal filtering technique which increases processing throughput.

According to one aspect of the present invention there is provided a method of improving the processing throughput rate of an optimal filtering technique which performs measurement sampling and computes covariance and optimal gain comprising: performing measurement sampling at a first predetermined rate; computing covariance and optimal gain at a second predetermined rate less than said first predetermined rate; and combining said computed optimal gain with said measurement samples to perform optimal filtering. The said measurement samples may be separated by an interval $\Delta T$ and said computation of optimal gain be separated by an interval of $n\Delta T$ where n is greater than 1, said optimal gain for any time t being represented by $K(t,n\Delta T)$ and the gain for each measurement sample at time t being equal to $[K(t,n\Delta T)]/n$.

According to another aspect of the invention there is provided in an optimal filtering technique which performs measurement sampling and computation of covariance and optimal gain, the improvement comprising: performing said measurement sampling at a first rate; computing covariance and optimal gain at a second rate less than said first rate over a predetermined period; adjusting said computed optimal gain to produce a fixed optimal gain for each measurement sample over a predetermined period; and combining said fixed optimal gain with each measurement sample to produce said optimal filtering. The said measurement samples may be separated by an interval $\Delta T$ and said computations of optimal gain be separated by an interval $n\Delta T$ which equals said predetermined period where n is greater than 1, said fixed optical gain for each measurement sample being constant over the interval $n\Delta T$. Also, the said gain at time t may be defined as $K(t,n\Delta T)$ and the gain for each measurement sample be equal to $[K(t,n\Delta T)]/n$.

According to a further aspect of the invention, there is provided a navigation optimal filtering technique which performs measurement sampling from a plurality of satellites and computes the covariance and gain for each measurement sample comprising: performing measurement sampling of multiple satellite signals at a first predetermined rate over a predetermined period; computing

- 4 -                                    0121992

covariance and optimal gain at a second predetermined rate less than said first predetermined rate; deriving from said computed optimal gain a constant optimal gain for each measurement sample during said predetermined period; and combining said constant optimal gain with each said measurement sample to provide optimal filtering of said satellite signals.

In one embodiment of the present invention, a multirate optimal filtering technique is disclosed in connection with its use in a navigation system. In such a system, multiple inputs are received from a plurality of satellites forming a satellite-based navigation system. The navigation filter processes the information by performing measurement sampling at a given rate. The covariance and optimal gain computations are processed at a slower rate than the filter measurement computations to increase the throughput of the system. The covariance and gains are thus computed at one rate and appropriately adjusted and used by the measurement equations being processed at a higher rate. Since the optimal gain remains fairly constant for several consecutive measurements, the processing of the covariance and optimal gain at the lower rate does not significantly effect the accuracy of the estimation produced by the optimal filtering, but significantly increases the throughput time or the measurement sampling that may be performed for a fixed throughput time.

It is therefore a feature of the invention to provide an improved optimal filtering technique.

It is another feature of the invention to provide a multirate optimal filtering technique which allows greater processing throughput.

A still further feature of the invention is to provide a multirate optimal filtering technique which computes the covariance and optimal gain at a slower rate than the filter measurement computations.

Yet another feature of the invention is to provide a navigation system which employs a multirate optimal filtering technique having improved processing throughput times.

Still a further feature of the invention is to provide a navigation technique which allows multiple sensor input processing and sampling with reduced computations for covariance and optimal gain.

These and other advantages and novel features of the invention will become apparent from the following detailed description.

DETAILED DESCRIPTION OF A PREFERRED EMBODIMENT

Conventional optimal filtering techniques are well known in the prior art and will therefore not be described in great detail herein. Basic Kalman filtering techniques, for example, are one illustration of optimal filtering which may be used in a variety of systems to provide a best estimate for a measurement point in a given system. Reference may be made to Applied Optimal Estimation by Arthur Gelb, Editor, MIT Press, Cambridge, Mass.,1974, herein incorporated by reference, for a description of the basic Kalman filtering equations used for optimal covariance filtering. These techniques have been applied to a variety of problems including navigation and other multisensor systems.

Kalman filtering and similar techniques such as the square root and U-D covariance filtering techniques have been particularly useful in navigation systems. Various considerations govern the selection of the particular filtering technique under given circumstances and various arguments have been advanced relative to the accuracy and desirability of using a given filtering technique in a particular environment. In one example described in the article entitled, "Numerical Comparison of Kalman Filter Algorithms: Orbit Determination Case Study" by G J Bierman and C L Thornton, Automatica, Vol 13, No 1, Jan 1977, pp 23-36, herein incorporated by reference, various arguments are advanced with respect to the selection of one optimal filtering technique over the over. Again, this shows the current state-of-the-art filters and some of the criteria used to select their implementation in a given process.

0121992

The processing required for implementing the filtering equations depends upon the system dynamics. Thus, in some instances, a higher measurement sampling rate and computation of covariance and optimal gain is required to produce usable results. In those instances, the limitations are imposed by the capabilities of the processing system employed to perform the calculations. As the number of samples and calculations increases, the throughput time for the filtering equations is reduced and real-time estimates are not possible. Prior art systems are therefore limited in their applications to the capacity of the processing system and the throughput times of that system.

Navigation and process control systems are examples where the system dynamics are such that high measurement sampling rates are required. In such systems, such as a satellite-based navigation system which includes tracking from multiple satellites, the number of measurement samples that need to be made increases in direct proportion to the number of satellites used. Likewise, depending on the type of system application (e.g. navigation for position display vs. navigation for vehicular control along a specified path) so does the necessity for providing a higher sampling rate. In still other instances where the system state changes at a relatively rapid rate, more samples are needed thereby requiring higher throughput to produce optimal estimation with any accuracy. Accordingly, such multisensor navigation processing systems such as GPS, VOR/DME, VLF/Omega, where vehicle dynamics dictate high sampling rates, are severely restricted by the throughput rate of conventional processing systems. Likewise, in similar process control applications wherein homogeneous input mixtures require high sampling rates to provide estimates of the system state, conventional optimal filtering techniques are incapable of providing real-time filtering.

The effect of such limitations may be appreciated by way of example with respect to a vehicle navigation system. Assume that a satellite-based navigation system is utilized which includes the tracking of four satellites and requires four corresponding measurements. Next assume that the navigation filter employed is an eight-state filter with four process noise models. In a conventional environment, the size, weight and power considerations which would govern the selection of a processor would restrict the processor to equipment having floating point execution times of 30 μsec for division, 20 μsec for multiplication, 10 μsec for addition, and 2 μsec for logic operations. Under such circumstances, the throughput times for conventional Kalman filtering may be estimated in accordance with the techniques disclosed in the article "Computational Requirements for a Discrete Kalman Filter" by J M Mendel, IEEE Transactions on Automatic Control, AC-16, No 6, Dec 1971, pp 748-758 herein incorporated by reference.

Using the above technique it is estimated that the state update cycle would require 139 multiplications plus 128 additions plus 1783 logic operations, and the covariance and gain cycle would require 36 divisions plus 2965 multiplications plus 3488 additions and 35,805 logic operations. With the above noted execution times, the conventional Kalman filter would require 166,870 μsec per cycle. Throughput for such a filter would have to be limited to 5 percent and by processing one measurement per second (4 seconds per cycle), the filter loading would be 4.2 percent. As will be apparent, such filter loading is acceptable for low vehicle dynamic conditions such as those encountered for position display for trucks and tanks but not acceptable for aircraft navigation/flight control applications where a complete cycle each second is required. Under such circumstances, the conventional Kalman filter processor loading would be 16.7 percent and unacceptable for real-time applications.

In order to overcome the above noted limitations, it has been recognized that the optimal gain in such optimal filtering techniques generally remains fairly constant for several consecutive measurements at the measurement sampling rate. As a result, it has been determined that the covariance and optimal gain computations could be processed at a slower rate than the filter measurement computations. Under such conditions, the optimal gain computed by assuming the lower processing rate can be approximated without substantially reducing the accuracy of the optimal filtering technique. This may be achieved by allowing the interval between measurements to be $\Delta T$ and the interval between the covariance and gain computationd to be $n\Delta T$ where n is greater than unity. The optimal gain (also conventionally referred to as the measurement gain or Kalman gain) computed for time t is then given by $K(t,n\Delta T)$. The gain $K(t,\Delta T)$ used by the measurement processing equations around time t can then be approximated in accordance with the following equation:

$$K(t,\Delta T) \cong K(t,n\Delta T)/n \tag{1}$$

Using this approximation, the throughput for the covariance and gain computations increases n-fold. Thus, in the previous example with respect to filtering throughput for trucks and tanks using the four satellite navigation system, the same can be recalculated using the identical execution times to recalculate the filter loading for aircraft.

By way of example, if the covariance and gain are processed every five seconds and all four measurements are made every second, the throughput requirements reduce the filter loading to 4.1 percent, which is acceptable for real-time applications. It can therefore be seen that by application of the above technique, the same process and similar software can be used for both applications wherein conventional systems would be incapable of handling both. The multirate scheme is therefore capable of extending the system operation in accordance with the restrictions produced by size, weight and power. The greater measurement throughput thereby allows more versatility than conventional covariance filtering techniques.

The success of the above technique can be understood by considering the operation of both discrete and continuous filters. If $X(k\Delta T)$ is used to indicate the state descriptor for a discrete estimation process at a time $k\Delta T$, and $K(k\Delta T)$ is used to identify the gain computed by an optimal covariance filter, then the optimal estimator state is updated by a measurement $y(k\Delta T)$ as follows:

0121992

$$X[(k+1)\Delta T] = X(k\Delta T) + K(k\Delta T)[y(k\Delta T) - H(k\Delta T)X(k\Delta T)] \qquad (2)$$

where $H(k\Delta T)$ is the observation matrix. Rearranging the above equation results in:

$$X[(k+1\Delta T] - X(k\Delta T) = -K(k\Delta T)X(k\Delta T)H(k\Delta T) + K(k\Delta T)y(k\Delta T) \qquad (3)$$

It will be recognized, that if the measurement rate is sufficiently great, the discrete measurement process and a continuous measurement process will yield the same optimal performance. It is well known that as the sample interval, $\Delta T$, approaches zero, the continuous optimal gain, $K(t)$, is related to the discrete gain as follows:

$$\lim_{\Delta T \to 0} \left. \frac{K(k\Delta T)}{\Delta T} \right|_{t=K\Delta T} = \overline{K}(t) \qquad (4)$$

and the previous equation for the optimal continuous state becomes:

$$dx/dt \overset{\Delta}{=} \lim_{\Delta T \to 0} \frac{X[k+1)\Delta T] - X(k\Delta T)}{\Delta T} \qquad (5)$$

$$= \overline{K}(t)H(t)X(t) + \overline{K}(t)y(t) \qquad (6)$$

Since both the discrete and continuous process represented by equations (3) and (6) yield the identical performance and are related by equation (4), it is seen that the relationship for optimal discrete gains for different sampling rates as approximated in equation (1) is accurate. Accordingly, equation (1) defines the computation of gain that may be used in the measurement processing equations.

As a result of the above, it will be seen that implementation of the above technique produces an optimal filtering technique which includes multiple rates, in that measurement sampling is performed at one rate and the covariance and optimal gain computations are processed at a slower rate. The gain is adjusted in accordance with the time interval over which the sampling is performed to produce a fixed gain which is applied to the rate measurements made at higher processing speeds over the same time interval. With this reduced computational requirement, the throughput is increased, thereby allowing more measurements to be made with a given hardware system or faster measurements to be made with the same hardware system. Under such circumstances, the ability of a given system to process measurements under different dynamic conditions is improved, rendering the system more versatile without significant changes in the software.

As can be seen by the above description, the present invention provides an improved filtering technique which uses multirate sampling for measurements and covariance and optimal gain computations. The measurement sampling rate is fixed at one value while the covariance and optimal gain computations are processed at a slower rate and used with the measurement equations over a selected interval. This allows improved processing in multisensor measurement systems and higher sampling rates subject to high dynamic changes. The system may be implemented with conventional data processing and programming techniques and used in conventional computers and microprocessors to produce reduced throughput times, or increased processing capabilities. All of these are features which are not taught or suggested by the prior art.

While the above invention has been described with respect to its application in Kalman filtering techniques, it is equally applicable in other optimal covariance filtering systems including square root, U-D, and other similar techniques. Obviously, many other modifications and variations of the invention are possible in light of the above teachings. It is therefore to be understood that within the scope of the appended claims the invention may be practiced otherwise than as specifically described.

CLAIMS

1.   A method of improving the processing throughput rate of an optimal filtering technique which performs measurement sampling and computes covariance and optimal gain comprising:

performing measurement sampling at a first predetermined rate;

computing covariance and optimal gain at a second predetermined rate less than said first predetermined rate; and

combining said computed optimal gain with said measurement samples to perform optimal filtering.

2.   The method of claim 1 wherein said measurement samples are separated by an interval $\Delta T$ and said computation of optimal gain is separated by an interval of $n\Delta T$ where n is greater than 1, said optimal gain for any time t being represented by $K(t, n\Delta T)$ and the gain for each measurement sample at time t being equal to $[K(t,n\Delta T)]/n$.

3.   In an optimal filtering technique which performs measurement sampling and computation of covariance and optimal gain, the improvement comprising:

performing said measurement sampling at a first rate;

computing covariance and optimal gain at a second rate less than said first rate over a predetermined period;

adjusting said computed optimal gain to produce a fixed optimal gain for each measurement sample over a predetermined period; and

combining said fixed optimal gain with each measurement sample to produce said optimal filtering.

4.   The method of claim 3 wherein said measurement samples are separated by an interval $\Delta T$ and said computations of optimal gain are separated by an interval $n\Delta T$ which equals said predetermined period where n is greater than 1, said fixed optimal gain for each measurement sample being constant over the interval $n\Delta T$.

- 12 -

0121992

5. The method of claim 4 wherein said gain at time t is defined as K(t,nΔT) and the gain for each measurement sample is equal to [K(t,nΔT)]/n.

6. A navigation optimal filtering technique which performs measurement sampling from a plurality of satellites and computes the covariance and gain for each measurement sample comprising:

performing measurement sampling of multiple satellite signals at a first predetermined rate over a predetermined period;

computing covariance and optimal gain at a second predetermined rate less than said first predetermined rate;

deriving from said computed optimal gain a constant optimal gain for each measurement sample during said predetermined period; and

combining said constant optimal gain with each said measurement sample to provide optimal filtering of said satellite signals.